# EUROPÄISCHE PATENTSCHRIFT

(11) **EP 2 608 160 B1**
(45) Veröffentlichungstag und Bekanntmachung des Hinweises auf die Patenterteilung: **20.03.2019**
(21) Anmeldenummer: 12008462.9
(22) Anmeldetag: 19.12.2012
(51) Int. Cl.: G07D 7/04

(54) **Verfahren für die Kompensation von Störungen bei magnetischen Messungen an Wetdokumenten**
Method for the compensation of disturbances in magnetic measurements on vakuable documents
Procédé de compensation de perturbations dans des mesures magnétiques sur des documents de valeur.

(30) Priorität: 21.12.2011 DE 102011121876
(43) Veröffentlichungstag der Anmeldung: 26.06.2013
(73) Patentinhaber: Giesecke+Devrient Currency Technology GmbH, 81677 München (DE)
(72) Erfinder: Steffen, Schmalz, 81375 München (DE); Schütt, Lothar, 85221 Dachau (DE); Schützmann, Jürgen, 85276 Pfaffenhofen (DE)

(56) Entgegenhaltungen:
- EP-A2- 0 883 092
- DE-A1- 3 738 455

## Beschreibung

Die vorliegende Erfindung betrifft ein Verfahren für die Kompensation von Störungen bei magnetischen Messungen an Wertdokumenten.

Die Prüfung von Wertdokumenten ist von großer Bedeutung, da die Wertdokumente anhand der Überprüfung beispielsweise in Wertdokumente eingeteilt werden, die echt, gefälscht oder fälschungsverdächtig sind. Ebenso wird bei der Überprüfung der Wertdokumente ermittelt, um welche Art von Wertdokument es sich handelt, also beispielsweise bei einer Banknote deren Währung und Denomination. Üblicherweise werden mittels Sensoren magnetische Messungen an den Wertdokumenten vorgenommen, wozu die zu prüfenden Wertdokumente an den Sensoren vorbei transportiert werden, und die Messsignale der Sensoren zur Überprüfung der Wertdokumente ausgewertet werden. Neben Banknoten können weitere Wertdokumente wie Schecks, Tickets, Coupons usw. in gleicher Weise geprüft werden.

Die Wertdokumente weisen Sicherheitselemente auf, wie z. B. Sicherheitsstreifen, Sicherheitsfäden oder Aufdrucke, die magnetische bzw. magnetisierbare Materialien enthalten. Zur magnetischen Kodierung eines Sicherheitselements kann auch eine bestimmte, charakteristische Abfolge von magnetischen und nichtmagnetischen Bereichen dienen, deren Anordnung eine charakteristische und maschinenprüfbare Kodierung des Wertdokuments darstellt, die wie oben beschrieben, mittels Sensoren ermittelt werden, um die magnetische Kodierung auf diese Weise zu überprüfen.

Es hat sich jedoch gezeigt, dass die Überprüfung der magnetischen Eigenschaften der magnetischen Materialien der Sicherheitselemente hohe Anforderungen an die verwendeten Sensoren stellen, da nur geringe Mengen der magnetischen oder magnetisierbaren Materialien verwendet werden, weshalb die von den Sicherheitselementen ausgehenden magnetischen Felder bei der Überprüfung gering sind. Die Messung und Überprüfung der magnetischen Eigenschaften der Sicherheitselemente mittels der verwendeten Sensoren ist daher besonders anfällig für Störungen, z. B. elektromagnetische Störungen, wie sie beispielsweise im Umfeld elektrischer Maschinen auftreten. Ein derartiger Sensor mit einer Messspur und gegenüberliegendem Kompensationssensor ist beispielsweise aus DE 37 38 455 A1 bekannt.

Es ist deshalb Aufgabe der vorliegenden Erfindung, ein Verfahren für die Kompensation von Störungen bei magnetischen Messungen an Wertdokumenten anzugeben, welches eine verbesserte Überprüfung von magnetische oder magnetisierbare Materialien aufweisenden Sicherheitselementen erlaubt.

Diese Aufgabe wird erfindungsgemäß durch die Merkmale des Anspruchs 1 gelöst.

Die Erfindung geht dabei von einem Verfahren für die Kompensation von Störungen bei magnetischen Messungen an Wertdokumenten, bei dem ein Sensor mit mehreren Messspuren zur Erzeugung von Messsignalen verwendet wird, bei dem für jedes Wertdokument eine vorgegebene Anzahl von Datensätzen erzeugt wird, wobei das Wertdokument während der Messung zumindest von einer der Messspuren nicht erfasst wird, aus, wobei aus dem Messsignal der zumindest einen Messspur ein Wert für die Größe einer während der Messung an dem Wertdokument im Bereich des Sensors vorhandenen Störung ermittelt wird, und eine Kompensation der durch die während der Messung vorhandenen Störung verursachten Abweichungen der Messsignale der das Wertdokument erfassenden Messspuren mittels des ermittelten Werts für die Größe der vorhandenen Störung durchgeführt wird.

Die Erfindung weist somit insbesondere den Vorteil auf, dass Messungen mit Sensoren für magnetische Eigenschaften an Wertdokumenten auch dann sicher und korrekt durchgeführt werden können, wenn während der Messung starke Störungen auftreten, beispielsweise elektromagnetische Störungen im Umfeld von elektrischen Maschinen und starke Ströme führenden elektrischen Leitungen.

In einer erfindungsgemäßen Weiterbildung ist es vorgesehen, dass zusätzlich mindestens ein Wert für die Größe der Störungen innerhalb eines Wertdokuments für einen Bereich, an dem keine magnetischen oder magnetisierbaren Materialien vorhanden sind, mittels mindestens einer der das Wertdokument erfassenden Messspuren ermittelt wird.

Die Weiterbildung weist den Vorteil auf, dass durch die Bestimmung der an weiteren Messspuren des Sensors vorliegenden Störungen insgesamt eine genauere und damit weiter verbesserte Kompensation der auftretenden Störungen ermöglicht wird.

Weitere Vorteile der vorliegenden Erfindung ergeben sich aus den abhängigen Ansprüchen sowie der nachfolgenden Beschreibung von Ausführungsformen anhand von Figuren.

Es zeigt:
- Figur 1: eine Banknotenbearbeitungsmaschine für die Bearbeitung und Überprüfung von Wertdokumenten mit magnetischen Sicherheits-elementen,
- Figur 2: einen Sensor zur Messung von magnetischen Eigenschaften sowie von diesem Sensor in einer ersten Messung gemessene magnetische Eigenschaften eines Wertdokuments,
- Figur 3: eine im Frequenzraum dargestellte Leistungsverteilung eines Mess-signals des Sensors zur Messung von magnetischen Eigenschaften aus Figur 2,
- Figur 4: den Sensor zur Messung von magnetischen Eigenschaften aus Figur 2 sowie von diesem Sensor in einer zweiten Messung gemessene magnetische Eigenschaften eines Wertdokuments,
- Figur 5: ein Diagramm von Amplituden von Messsignalen einzelner Mess-spuren des Sensors aus Figur 4, und
- Figur 6: den Sensor zur Messung von magnetischen Eigenschaften aus Figur 2 sowie von diesem Sensor gemessene magnetische Eigenschaften eines Wertdokuments.

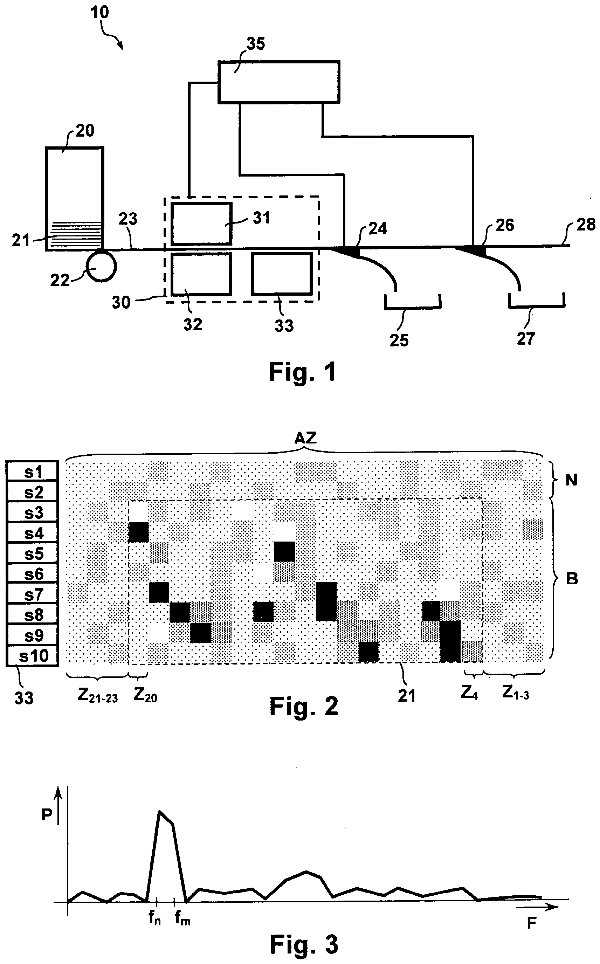

Figur 1 zeigt eine Banknotenbearbeitungsmaschine 10 für die Bearbeitung und Überprüfung von Wertdokumenten mit magnetischen Sicherheitselementen, die nachfolgend beispielhaft als Banknoten bezeichnet werden.

Die Banknotenbearbeitungsmaschine 10 weist ein Eingabefach 20 für die Eingabe von zu bearbeitenden Banknoten 21 auf, in welches ein Vereinzeler 22 eingreift. Der Vereinzeler 22 erfasst jeweils eine der zu bearbeitenden Banknoten 21 und übergibt die einzelne Banknote an ein Transportsystem 23, welches die einzelne Banknote durch eine Sensoranordnung 30 transportiert.

In der Sensoranordnung 30 sind Sensoren 31, 32, 33 vorhanden, beispielsweise ein erster optischer Sensor 31, der von der Banknote remittiertes Licht erfasst, ein zweiter optischer Sensor 32, der durch die Banknote transmittiertes Licht erfasst, und ein dritter Sensor 33 für die Messung von magnetischen Eigenschaften der Banknote. Die Sensoren 31, 32, 33 führen für die Überprüfung der Banknoten Messungen durch, bei der sie Eigenschaften jeder einzelnen Banknote erfassen und entsprechende Messsignale erzeugen. Dazu erfassen die Sensoren 31, 32,33 die Banknoten mit einer bestimmten Auflösung, aus der sich eine Bildpunktgröße ergibt, mit der die Banknoten abgetastet und erfasst werden.

Aus den Messsignalen der Sensoren 31, 32, 33 für die erfassten Bildpunkte jeder der Banknoten werden von einer Steuereinrichtung 35 Messdaten gebildet, welche jeden Ort auf der Oberfläche der jeweiligen Banknote repräsentieren. Bevorzugt werden die jeweiligen Banknoten vollständig erfasst und entsprechende Messdaten für die vollständige Banknote erzeugt.

Aus den Messdaten leitet die Steuereinrichtung 35 Eigenschaften ab, die für die Überprüfung der Banknoten relevant sind. Diese Eigenschaften charakterisieren die jeweilige Banknote und erlauben beispielsweise die Überprüfung deren Echtheit oder die Ermittlung einer bestimmten Währung und/oder Denomination. Die jeweiligen Eigenschaften können beispielsweise aus den Messdaten eines oder mehrerer der Sensoren 31, 32, 33 abgeleitet werden, beispielsweise aus den Messdaten der magnetischen Eigenschaften des Sensors 33. Aus den Messdaten der magnetischen Eigenschaften kann dabei die An- und/oder Abwesenheit von magnetischen oder magnetisierbaren Materialien an bestimmten Stellen der jeweiligen Banknote erkannt werden. In der Steuereinrichtung 35 werden die Messdaten weiter verarbeitet und dazu z. B. mit in der Steuereinrichtung 35 gespeicherten Referenzdaten verglichen, woraufhin die Steuereinrichtung 35 Aussagen beispielsweise zur Echtheit, Währung, Denomination usw. der jeweiligen Banknote ableitet.

Anhand der von der Steuereinrichtung 35 durchgeführten Überprüfung der jeweiligen Banknote werden im Transportsystem 23 angeordnete Weichen 24, 26 angesteuert, z. B. um Banknoten einer bestimmten Denomination in einem Ausgabefach 25 abzulegen, wohingegen Banknoten anderer Denomination in einem Ausgabefach 27 abgelegt werden können. Über das Transportsystem 23 können die Banknoten einer weiteren Bearbeitung 28 zugeführt werden, z.B. der Ablage in weiteren Ausgabefächern oder der Zerstörung mittels eines nicht dargestellten Schredders.

Wie bereits erwähnt, werden aus den Messsignalen der Sensoren 31, 32, 33 bzw. den Messdaten Eigenschaften abgeleitet, die eine Bewertung der Banknoten durch die Steuereinrichtung 35 ermöglichen. Dies wird nachfolgend für die Messsignale des Sensors 33 für magnetische Eigenschaften näher erläutert.

Figur 2 zeigt den Sensor 33 zur Messung von magnetischen Eigenschaften sowie von diesem Sensor 33 in einer ersten Messung gemessene magnetische Eigenschaften eines Wertdokuments 21, nachfolgend Banknote 21 genannt.

In Figur 2 dargestellt sind Messsignale des Sensors 33, welcher 10 Messspuren s1 bis s10 aufweist. Hell dargestellte Messsignale werden verwendet, falls bei der Messung kein oder nur sehr wenig magnetisches oder magnetisierbares Material vorhanden ist. Dunkler dargestellte Messsignale werden verwendet, falls bei der Messung mehr magnetisches oder magnetisierbares Material vorhanden ist.

Die dargestellten Messsignale des Sensors 33 bzw. der Messspuren s1 bis s10 werden erzeugt, wenn die Banknote 21 in der Ebene der Darstellung der Figur 2 von links nach rechts über den Sensor 33 transportiert wird. Während des Transports der Banknote 21 werden die Messsignale des Sensors 33 in regelmäßigen Abständen durch die Steuereinrichtung 35 erfasst, wodurch aus den Messsignalen der Messspuren s1 bis s10 des Sensors 33 jeweils ein Datensatz Zi mit zehn Messsignalen für die Messspuren s1 bis s10 gebildet wird. Insgesamt wird für eine Banknote 21 eine vorgegebene Anzahl AZ derartiger Datensätze Zi erzeugt. Die Anzahl AZ der erzeugten Datensätze Zi ergibt sich im Wesentlichen aus der maximalen Länge der zu bearbeitenden Banknote und der gewünschten räumlichen Auflösung der Messung. Im dargestellten Beispiel werden 23 Datensätze Zi mit i = 1 bis 23 erzeugt. Die Banknote 21 (in Figur 2 gestrichelt angedeutet) wird im dargestellten Beispiel von den Messspuren s3 bis s10 über ihre Breite B erfasst, wobei ihre Messsignale in den Datensätzen Z₄ bis Z₂₀ enthalten sind. Die Signale der nicht von der Banknote 21 abgedeckten Messspuren s1, s2 liefern keine Messsignale für die Banknote 21 sondern Messsignale N für einen banknotenfreien Hintergrund im Bereich des Sensors 33. Jeweils drei Datensätze vor Z₁₋₃ und nach Z₂₁₋₂₃ der Banknote 21 sind ebenfalls banknotenfrei und stellen ebenfalls den Hintergrund des Sensors 33 da. Die Datensätze vor Z₁₋₃ und nach Z₂₁₋₂₃ der Banknote 21 können sich durch Abstände ergeben, die zwischen zu bearbeitenden Banknoten einzuhalten sind.

Da die Banknoten 21 nur geringe Mengen an magnetischen oder magnetisierbaren Materialien aufweisen, führen Störungen, wie sie in elektrischen Maschinen, z. B. der verwendeten Banknotenbearbeitungsmaschine 10 in Form von elektromagnetischen Störungen auftreten können, zu erheblichen Abweichungen der vom Sensor 33 erzeugten Messsignale von den tatsächlich zu erwartenden Werten.

Um die in den Messsignalen auftretenden Abweichungen zu kompensieren, werden die bei der Messung mit dem Sensor 33 auftretenden Störungen ermittelt und von der Steuereinrichtung 35 bei der Bildung von Messdaten aus den Messsignalen des Sensors 33 berücksichtigt. Dazu werden die Messsignale mindestens einer der Messspuren s1, s2 des Sensors 33 verwendet, die keine Messsignale für die Banknote 21 liefern, sondern Messsignale für den banknotenfreien Hintergrund des Sensors 33. Diese Messsignale des Hintergrunds repräsentieren im Wesentlichen die während der Messung vorhandenen Störungen im Bereich des Sensors 33. Zur Kompensation der Störungen werden die Messsignale N bzw. die Messsignale einer oder mehrerer der banknotenfreien Messspuren s1, s2 von der Steuereinrichtung 35 ausgewertet, um einen Wert für die Größe der vorhandenen Störungen zu ermitteln. Bei der Erzeugung der Messdaten für die Banknote 21 aus den Messsignalen B der Messspuren s3 bis s10 des Sensors in den Datensätzen Z₄ bis Z₂₀ wird von der Steuereinrichtung 35 der aus den Messsignalen der Messspuren s1, s2 ermittelte Wert für die Größe der Störungen verwendet, um die im Bereich des Sensors 33 vorhandenen Störungen zu kompensieren.

Für die beschriebene Störungskompensation kann es vorgesehen sein, dass der bei der Kompensation zu berücksichtigende Wert für die vorhandenen Störungen als Mittelwert gebildet wird. Dazu werden die in der gesamten Anzahl AZ der Datensätze Zi enthalten Messsignale mindestens einer der banknotenfreien Messspuren s1, s2 verwendet. Es kann aber auch vorgesehen sein, dass die Ermittlung des Werts für die vorhandenen Störungen für die Messsignale jedes der Datensätze Zᵢ oder als Mittelwert jeweils für mehrere der Datensätze Zᵢ erfolgt.

In Figur 3 ist eine Leistungsverteilung eines Messsignals des Sensors 33 zur Messung von magnetischen Eigenschaften im Frequenzraum dargestellt.

Dazu wird das Messsignal einer oder beider banknotenfreien Messspuren s1, s2 beispielsweise mittels einer Fouriertransformation in den Frequenzraum transformiert. Im Frequenzraum werden in der Leistungsverteilung auftretende lokale Maxima bestimmt und zugeordnete Frequenzen fₙ, fₘ ermittelt. Alle diese Frequenzen fₙ, fₘ können Störfrequenzen darstellen. Es kann aber auch vorgesehen sein, nur die Frequenz als Störfrequenz zu berücksichtigen, welche die größte Leistung aufweist (absolutes Maximum), oder die Frequenzen, deren Leistung einen vorgegebenen Wert übersteigt. In elektrischen Maschinen, wie der verwendeten Banknotenbearbeitungsmaschine 10, werden die Störfrequenzen fₙ, fₘ häufig von der Netzfrequenz oder von Vielfachen der Netzfrequenz gebildet. Der Signalanteil der ermittelten Störfrequenz fₙ, fₘ wird dann für die Messdaten aus den Messsignalen B der die Banknote 21 erfassenden Messspuren s3 bis s10 entfernt. Dazu werden die Messsignale der Messspuren s3 bis s10 ebenfalls in den Frequenzraum transformiert, wo die ermittelte Störfrequenz oder die ermittelten Störfrequenzen fₙ, fₘ entfernt wird oder werden. Nach einer anschließenden Rücktransformation in den Zeitbereich liegen Messdaten für die Messspuren s3 bis s10 vor, die hinsichtlich der bei der Messung vorhandenen Störungen kompensiert sind.

Ebenso ist es möglich, statt die ermittelten Störfrequenzen vollständig aus den Messsignalen für die Messspuren s3 bis s10 zu entfernen, deren Leistung im Frequenzraum zu reduzieren oder eine Mittelwertbildung für die Leistung der jeweiligen Störfrequenz zusammen mit der Leistung von Nachbarfrequenzen der jeweiligen Störfrequenz vorzunehmen.

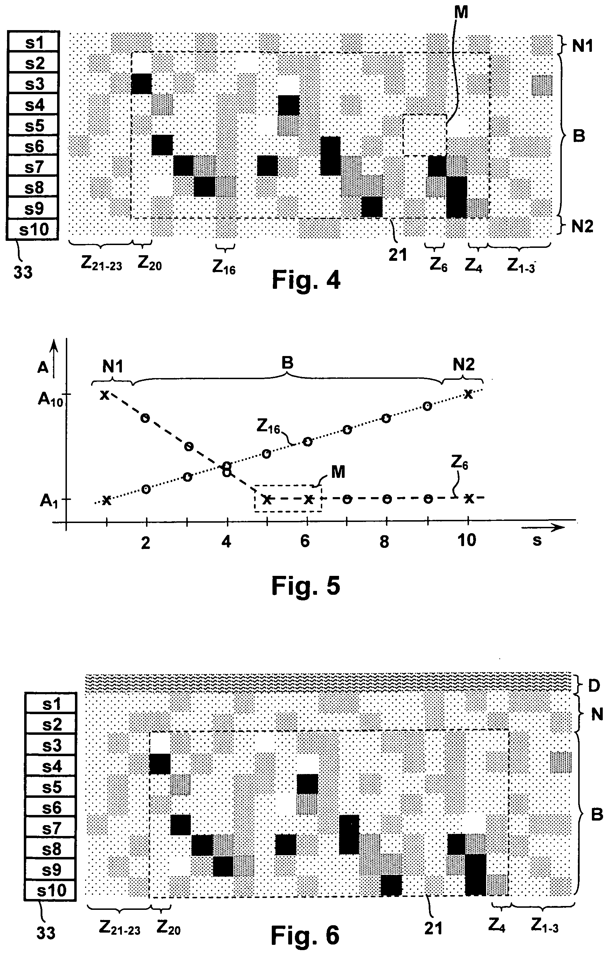

In Figur 4 ist der Sensor 33 zur Messung von magnetischen Eigenschaften aus Figur 2 sowie von diesem Sensor 33 in einer zweiten Messung gemessene magnetische Eigenschaften der Banknote 21 dargestellt.

In Figur 4 wird die Banknote 21 derart über den Sensor 33 transportiert, dass die Breite B der Banknote 21 die Messspuren s2 bis s9 abdeckt. Die Messspuren s1, s10 sind banknotenfrei, so dass ihre Messsignale N1, N2 den banknotenfreien Hintergrund im Bereich des Sensors 33 darstellen.

Figur 5 zeigt ein Diagramm von Amplituden von Messsignalen einzelner Messspuren des Sensors 33 aus Figur 4.

Dargestellt und mit Kreuzen x gekennzeichnet sind die Messsignale für die Messspuren s1 und s10 des Datensatzes Z₁₆. Da diese Messsignale den banknotenfreien Hintergrund im Bereich des Sensors 33 darstellen und damit im Wesentlichen der Signalamplitude der im Bereich des Sensors 33 auftretenden Störungen entsprechen, können sie für eine Kompensation der im Bereich des Sensors 33 auftretenden Störungen verwendet werden. Dazu wird für die zwischen den Messspuren s1 und s10 liegenden Messspuren s2 bis s9 eine Interpolation, ausgehend von den Messsignalen der Messspuren s1 und s10, vorgenommen. Beispielsweise kann, wie in Figur 5 dargestellt, eine lineare Interpolation vorgenommen werden. Dabei ergeben sich die mit Kreisen o gekennzeichneten Amplitudenwerte für die Messspuren s2 bis s9. Zur Kompensation der Störungen werden die derart durch Interpolation ermittelten Amplitudenwerte für die Störungen bei der Erzeugung der Messdaten durch die Steuereinrichtung 35 berücksichtigt, beispielsweise durch Subtraktion der interpolierten Amplitudenwerte von den entsprechenden Signalamplituden der Messsignale der jeweiligen Messspuren s2 bis s9.

Im dargestellten Beispiel wurde eine lineare Interpolation durchgeführt, ebenso kann eine sigmoidale, polynomische oder Spline-Interpolation durchgeführt werden.

Bestimmte Arten von Banknoten, z. B. einer bestimmten Währung und Denomination, können einen oder mehrere Bereiche M innerhalb der Banknote 21 aufweisen, in dem oder in denen keine magnetischen oder magnetisierbaren Materialien vorhanden sind. Falls bekannt ist, welche Art von Banknote gerade bearbeitet wird, z. B. weil gerade nur 10 Euro Banknoten bearbeitet werden, oder falls die Art der Banknote bei der Bearbeitung erkannt werden kann, z. B. durch eine Auswertung der Signale der anderen Sensoren 31, 32 durch die Steuereinrichtung 35, können zusätzlich auch Messsignale im Bereich der Banknote 21 verwendet werden, um weitere Werte für die Größe der im Bereich des Sensors auftretenden Störungen zu ermitteln. Dies ist deshalb möglich, weil an diesen Stellen - wie im banknotenfreien Sensorhintergrund der Messspuren - das Messsignal null sein sollte. Abweichungen von null stellen im Wesentlichen im Bereich des Sensors 33 vorhandene Störungen dar.

Dies ist in Figur 5 beispielsweise für den Datensatz Z₆ dargestellt. Neben den Messsignalen der banknotenfreien Messspuren s1 und s10 können auch die Messsignale der innerhalb der Banknote 21 liegenden Messspuren s5 und s6 im Bereich M verwendet werden, weil für die bekannte zu prüfende Banknote 21 auch bekannt ist, dass im Bereich M der Banknote 21, keine magnetischen oder magnetisierbaren Materialien vorhanden sind. Durch die Verwendung der zusätzlichen Stützstellen der Messsignale der Messspuren s5 und s6 im Bereich M wird die Interpolation für die Messspuren s2 bis s4 und s7 bis s9 verbessert, weshalb eine verbesserte Kompensation der Störungen ermöglicht wird.

Werte für die Kompensation der in den jeweiligen Messspuren vorhandenen Störungen können, wie zuvor beschrieben, für jeden der Datensätze Zi erzeugt werden. Es ist aber auch möglich, entsprechende Werte für die Kompensation der vorhandenen Störungen durch eine Mittelung der Messsignale mehrerer Datensätze Zi oder durch Mittelung der Messsignale der gesamten Anzahl AZ der Datensätze Zᵢ zu erzeugen.

Figur 6 zeigt den Sensor 33 zur Messung von magnetischen Eigenschaften aus Figur 2 sowie die gemessenen magnetischen Eigenschaften der Banknote 21.

Die Messsignale N, B sind um zusätzliche Daten D erweitert. Die zusätzlichen Daten D weisen dabei eine Datenstruktur auf, die der Datenstruktur der Messsignale N, B entspricht. Dadurch wird es ohne großen Aufwand möglich, Zusatzinformationen über die Messsignale N, B und ihr Zustandekommen zu den Messsignalen N, B hinzuzufügen, z. B. um die Messsignale N, B speichern oder archivieren zu können. Die zusätzlichen Daten D erlauben eine spätere Erkennung und Auswertung der gespeicherten Messsignale N, B. Die zusätzlichen Daten D können beispielsweise Angaben zum Ort und Zeitpunkt der Erzeugung der Messsignale N, B oder zum für die Erzeugung der Messsignale N, B verwendeten Sensortyp enthalten. Dazu kann der Sensor beispielsweise mittels einer Seriennummer gekennzeichnet sein, die dann den zusätzlichen Daten D hinzugefügt wird. Weitere Angaben über den Sensor können Informationen zur Version der Hardware, zu Abgleichdaten, Abgleichzeitpunkt usw. umfassen. Eine aufwändige Archivierung oder Verwaltung der Messsignale N, B ist somit nicht erforderlich.

Statt die zusätzlichen Daten D wie dargestellt zeilenförmig anzuordnen, können die zusätzlichen Daten D auch spaltenförmig wie ein zusätzlicher Datensatz Zᵢ angeordnet werden. Statt die zusätzlichen Daten D in zusätzliche Zeilen oder Spalten zu schreiben, können auch Zeilen oder Spalten der Messsignale N, B verwendet werden, die keine Messsignale der Banknote 21 enthalten, also die mit N gekennzeichneten Zeilen oder die mit Z₂₁₋₂₃ oder Z₁₋₃ gekennzeichneten Spalten. Ebenso können die Daten D in andere nicht belegte oder genutzte Bereiche der Messsignale geschrieben werden, beispielsweise in die oben beschriebenen Bereiche M, die keine magnetischen oder magnetisierbaren Materialien aufweisen. Werden die Daten D in die Bereiche M oder in die Zeilen der Messsignale N eingefügt, ist darauf zu achten, dass eine Kompensation der Störungen dann für den Fall nicht mehr möglich ist, dass die zusätzlichen Daten D die Bereich M oder die Messsignale N vollständig ersetzen. In diesem Fall kann es aber auch vorgesehen sein, dass bereits ermittelte Werte für die Größe der Störungen mit in die zusätzlichen Daten D aufgenommen werden.

Neben der beschriebenen Verwendung der zusätzlichen Daten D zur Kennzeichnung von Messsignalen des Magnetsensors 33 können entsprechende zusätzliche Daten D auch zur Kennzeichnung der Messsignale anderer Sensoren, z. B. der optischen Sensoren 31, 32, verwendet werden, denen sie in der zuvor beschriebenen Weise hinzugefügt werden.

Bisher wurde die Erfindung anhand einer Banknotenbearbeitungsmaschine beschrieben, es ist aber offensichtlich, dass die Erfindung überall dort eingesetzt werden kann, wo Banknoten oder andere Wertdokumente automatisch hinsichtlich ihrer magnetischen Eigenschaften beurteilt werden.

Abweichend von der Beschreibung ist es auch möglich, dass statt nur einer zentralen Steuereinrichtung 35 eine Steuereinrichtung in jedem Sensor vorgesehen sein kann. Die Verknüpfung der Daten der einzelnen Sensoren erfolgt in diesem Fall in einer der Steuereinrichtungen der Sensoren oder in einer zentralen Steuereinrichtung.

In der vorherigen Beschreibung wurde ein Sensor 33 mit zehn Messspuren beschrieben, es ist offensichtlich, dass andere Sensoren mehr oder weniger Spuren aufweisen können. Es muss nur sichergestellt sein, dass mindestens eine der Messspuren bei den Messungen nicht von einer Banknote abgedeckt wird. Die Anzahl der verwendeten Messspuren ist von der Breite der zu untersuchenden Banknoten sowie von der gewünschten örtlichen Auflösung abhängig.

Ebenso ist offensichtlich, dass der Transport der Banknoten nicht nur, wie im vorliegenden Beispiel beschrieben, parallel zu den langen Kanten der Banknoten erfolgen kann. Die Banknoten können auch parallel zu ihren kurzen Kanten transportiert werden.

Die zuvor beschriebenen Verfahren zur Kompensation von Störungen bei magnetischen Messungen an Wertdokumenten können einzeln oder kombiniert eingesetzt werden, um die Qualität der erzeugten Messdaten für magnetische oder magnetisierbare Materialien aufweisende Wertdokumente zu verbessern.

## Patentansprüche

1. Verfahren für die Kompensation von Störungen bei magnetischen Messungen an Wertdokumenten, bei dem ein Sensor (33) mit mehreren Messspuren (s1 bis s10) zur Erzeugung von Messsignalen verwendet wird, bei dem für jedes Wertdokument (21) eine vorgegebene Anzahl (AZ) von Datensätzen (Zᵢ) erzeugt wird, wobei das Wertdokument (21) während der Messung zumindest von einer der Messspuren (s1, s2; s1, s10) nicht erfasst wird, **dadurch gekennzeichnet,**
**dass** aus dem Messsignal der zumindest einen Messspur (s1, s2; s1, s10) ein Wert für die Größe einer während der Messung an dem Wertdokument (21) im Bereich des Sensors (33) vorhandenen Störung ermittelt wird, und
**dass** eine Kompensation der durch die während der Messung vorhandenen Störung verursachten Abweichungen der Messsignale der das Wertdokument (21) erfassenden Messspuren (s3 bis s10; s2 bis s9) mittels des ermittelten Werts für die Größe der vorhandenen Störung durchgeführt wird.

2. Verfahren nach Anspruch 1, **dadurch gekennzeichnet, dass** der Wert für die Größe der Störung für jeden Datensatz (Zᵢ) erzeugt wird.

3. Verfahren nach Anspruch 1, **dadurch gekennzeichnet, dass** der Wert für die Größe der Störung für mehrere Datensätze (Zᵢ) oder die Anzahl (AZ) der Datensätze (Zᵢ) des Wertdokuments (21) erzeugt wird.

4. Verfahren nach einem der Ansprüche 1 bis 3, **dadurch gekennzeichnet, dass** das Messsignal der zumindest einen Messspur (s1, s2; s1, s10) in den Frequenzraum transformiert wird, und als Wert für die Größe der Störung mindestens eine Frequenz ermittelt wird, an der das transformierte Signal lokale Maxima aufweist, und dass die Messsignale der das Wertdokument (21) erfassenden Messspuren (s3 bis s10; s2 bis s9) in den Frequenzraum transformiert werden, um die transformierten Signale an der ermittelten mindestens einen Frequenz zu verändern, woraufhin die transformierten Signale der das Wertdokument (21) erfassenden Messspuren (s3 bis s10; s2 bis s9) für die weitere Verarbeitung in den Zeitbereich zurück transformiert werden.

5. Verfahren nach Anspruch 4, **dadurch gekennzeichnet, dass** die Veränderung der transformierten Signale an der ermittelten mindestens einen Frequenz durch Entfernen der Signale an der ermittelten mindestens einen Frequenz erfolgt, oder durch Reduzieren der Signalwerte an der ermittelten mindestens einen Frequenz, oder durch eine Mittelwertbildung für die Signalwerte an der ermittelten mindestens einen Frequenz zusammen mit Signalwerten benachbarter Frequenzen.

6. Verfahren nach einem der Ansprüche 1 bis 5, **dadurch gekennzeichnet, dass** das Wertdokument (21) während der Messung zumindest von je einer der äußeren Messspuren (s1, s10) des Sensors (33) nicht erfasst wird, und dass je ein Wert für die Größe der Störungen für die äußeren Messspuren (s1, s10) des Sensors (33) ermittelt wird, wobei für die zwischen den äußeren Messspuren (s1, s10) liegenden inneren Messspuren (s2 bis s9) Werte für die Größe der Störungen durch Interpolation der Werte für die Größe der Störungen der äußeren Messspuren (s1, s10) abgeleitet werden.

7. Verfahren nach Anspruch 6, **dadurch gekennzeichnet, dass** zur Interpolation eine lineare, sigmoidale, polynomische oder Spline-Interpolation durchgeführt wird.

8. Verfahren nach einem der Ansprüche 1 bis 7, **dadurch gekennzeichnet, dass** zusätzlich mindestens ein Wert für die Größe der Störungen innerhalb eines Wertdokuments (21) für einen Bereich (M), an dem keine magnetischen oder magnetisierbaren Materialien vorhanden sind, mittels mindestens einer der das Wertdokument (21) erfassenden Messspuren (s3 bis s10; s2 bis s9) ermittelt wird.

9. Verfahren nach einem der Ansprüche 1 bis 8, **dadurch gekennzeichnet, dass** zu den Messsignalen (N, B) zusätzliche Daten (D) hinzugefügt werden, wobei die zusätzlichen Daten (D) die Messsignale (N, B) charakterisieren.

10. Verfahren nach Anspruch 9, **dadurch gekennzeichnet, dass** die zusätzlichen Daten (D) eine Datenstruktur aufweisen, welche der Datenstruktur der Messsignale (N, B) entspricht.

11. Verfahren nach Anspruch 9 oder 10, **dadurch gekennzeichnet, dass** die zusätzlichen Daten (D) Angaben über den verwendeten Sensor (33) sowie den Zeitpunkt der Erzeugung der Messsignale (N, B) umfassen.

## Claims

1. A method for the compensation of disturbances in magnetic measurements on value documents, in which a sensor (33) with a plurality of measuring tracks (s1 to s10) is employed to generate measuring signals, in which for each value document (21) a predetermined number (AZ) of data sets (Zᵢ) is generated, wherein the value document (21) is not detected by at least one of the measuring tracks (s1, s2; s1, s10) during the measurement, **characterized in that**
from the measuring signal of the at least one measuring track (s1, s2; s1, s10) a value is determined for the dimension of a disturbance present during the measurement on the value document (21) in the region of the sensor (33), and that a compensation of the deviations of the measuring signals of the measuring tracks (s3 to s10, s2 to s9) detecting the value document (21), said deviations being caused by the disturbance present during the measurement, is carried out by means of the determined value for the dimension of the disturbance present.

2. The method according to claim 1, **characterized in that** the value for the dimension of the disturbance is generated for each data set (Zᵢ).

3. The method according to claim 1, **characterized in that** the value for the dimension of the disturbance is generated for a plurality of data sets (Zᵢ) or the number (AZ) of the data sets (Zᵢ) of the value document (21).

4. The method according to any of claims 1 to 3, **characterized in that** the measuring signal of the at least one measuring track (s1, s2; s1, s10) is transformed into the frequency domain, and at least one frequency is determined as the value for the dimension of the disturbance at which frequency the transformed signal has local maxima, and **in that** the measuring signals of the measuring tracks (s3 to s10; s2 to s9) detecting the value document (21) are transformed into the frequency domain in order to change the transformed signals at the determined at least one frequency, whereupon the transformed signals of the measuring tracks (s3 to s10; s2 to s9) detecting the value document (21) are transformed back into the time domain for further processing.

5. The method according to claim 4, **characterized in that** the change of the transformed signals at the determined at least one frequency is effected by removing the signals at the determined at least one frequency, or by reducing the signal values at the determined at least one frequency, or by averaging for the signal values at the determined at least one frequency together with signal values of adjacent frequencies.

6. The method according to any of claims 1 to 5, **characterized in that** the value document (21) is not detected by at least respectively one of the outer measuring tracks (s1, s10) of the sensor (33) during the measurement, and that respectively one value for the dimension of the disturbances is determined for the outer measuring tracks (s1, s10) of the sensor (33), wherein for the inner measuring tracks (s2 to s9) lying between the outer measuring tracks (s1, s10), values for the dimension of the disturbances are derived by interpolating the values for the dimension of the disturbances of the outer measuring tracks (s1, s10).

7. The method according to claim 6, **characterized in that** for the interpolation, a linear, sigmoidal, polynomial or spline interpolation is carried out.

8. The method according to any of claims 1 to 7, **characterized in that** in addition at least one value for the dimension of the disturbances within a value document (21) for a region (M) on which no magnetic or magnetizable materials are present is determined by means of at least one of the measuring tracks (s3 to s10, s2 to s9) detecting the value document (21).

9. The method according to any of claims 1 to 8, **characterized in that** additional data (D) are added to the measuring signals (N, B), wherein the additional data (D) distinguish the measuring signals (N, B).

10. The method according to claim 9, **characterized in that** the additional data (D) have a data structure which corresponds to the data structure of the measuring signals (N, B).

11. The method according to claim 9 or 10, **characterized in that** the additional data (D) include information about the sensor (33) employed and the time of generating the measuring signals (N, B).

## Revendications

1. Procédé de compensation de perturbations lors de mesures magnétiques à des documents de valeur, dans lequel un capteur (33) à plusieurs pistes de mesure (s1 à s10) est utilisé pour la génération de signaux de mesure, dans lequel, pour chaque document de valeur (21), un nombre (AZ) prédéterminé de jeux de données (Zᵢ) est généré, cependant que le document de valeur (21), pendant la mesure, n'est pas saisi au moins par une des pistes de mesure (s1, s2; s1, s10),
**caractérisé en ce**
**que**, à partir du signal de mesure de la au moins une piste de mesure (s1, s2; s1, s10), une valeur pour l'ampleur d'une perturbation existante dans la zone du capteur (33) pendant la mesure au document de valeur (21) est déterminée, et en ce qu'une compensation des écarts des signaux de mesure des pistes de mesure (s3 à s10; s2 à s9) saisissant le document de valeur (21) causés par la perturbation existante pendant la mesure est effectuée au moyen de la valeur déterminée pour l'ampleur de la perturbation existante.

2. Procédé selon la revendication 1, **caractérisé en ce que** la valeur pour l'ampleur de la perturbation est générée pour chaque jeux de données (Zᵢ).

3. Procédé selon la revendication 1, **caractérisé en ce que** la valeur pour l'ampleur de la perturbation est générée pour plusieurs jeux de données (Zᵢ) ou pour le nombre (AZ) des jeux de données (Zᵢ) du document de valeur (21).

4. Procédé selon une des revendications de 1 à 3, **caractérisé en ce que** le signal de mesure de la au moins une piste de mesure (s1, s2; s1, s10) est transformé en l'espace de fréquence, et que,comme valeur pour l'ampleur de la perturbation, au moins une fréquence est déterminée, à laquelle le signal transformé présente des maxima locaux, et que les signaux de mesure des pistes de mesure (s3 à s10; s2 à s9) saisissant le document de valeur (21) sont transformés en l'espace de fréquence afin de modifier les signaux transformés à la au moins une fréquence déterminée, à la suite de quoi les signaux transformés des pistes de mesure (s3 à s10; s2 à s9) saisissant le document de valeur (21) sont, pour le traitement subséquent, retransformés dans le domaine temporel.

5. Procédé selon la revendication 4, **caractérisé en ce que** la modification des signaux transformés à la au moins une fréquence déterminée a lieu par enlèvement des signaux à la au moins une fréquence déterminée, ou par réduction des valeurs de signaux à la au moins une fréquence déterminée, ou par une constitution de valeur moyenne pour les valeurs de signaux à la au moins une fréquence déterminée en association avec des valeurs de signaux de fréquences voisines.

6. Procédé selon une des revendications de 1 à 5, **caractérisé en ce que** le document de valeur (21), pendant la mesure, n'est pas saisi au moins par respectivement une des pistes extérieures de mesure (s1, s10) du capteur (33), et **en ce que** respectivement une valeur pour l'ampleur des perturbations pour les pistes extérieures de mesure (s1, s10) du capteur (33) est déterminée, cependant que, pour les pistes intérieures de mesure (s2 à s9) se trouvant entre les pistes extérieures de mesure (s1, s10), des valeurs pour l'ampleur des perturbations sont déduites par interpolation des valeurs pour l'ampleur des perturbations des pistes extérieures de mesure (s1, s10).

7. Procédé selon la revendication 6, **caractérisé en ce que,** pour l'interpolation, une interpolation linéaire, sigmoïde, polynomiale ou par spline est effectuée.

8. Procédé selon une des revendications de 1 à 7, **caractérisé en ce que,** en outre, au moins une valeur pour l'ampleur des perturbations à l'intérieur d'un document de valeur (21) pour une zone (M) à laquelle il n'y a pas de matériaux magnétiques ou magnétisables est déterminée au moyen d'au moins une des pistes de mesure (s3 à s10; s2 à s9) saisissant le document de valeur (21).

9. Procédé selon une des revendications de 1 à 8, **caractérisé en ce que,** aux signaux de mesure (N, B), des données supplémentaires (D) sont ajoutées, cependant que les données supplémentaires (D) caractérisent les signaux de mesure (N, B).

10. Procédé selon la revendication 9, **caractérisé en ce que** les données supplémentaires (D) présentent une structure de données qui correspond à la structure de données des signaux de mesure (N, B).

11. Procédé selon la revendication 9 ou 10, **caractérisé en ce que** les données supplémentaires (D) comprennent des indications sur le capteur (33) utilisé ainsi que sur le moment de la génération des signaux de mesure (N, B).
